**Europäisches Patentamt**

**European Patent Office**

**Office européen des brevets**

(19)

(11) Numéro de publication: **0 046 102**
**A1**

(12)

# DEMANDE DE BREVET EUROPEEN

(21) Numéro de dépôt: **81401206.8**

(22) Date de dépôt: **28.07.81**

(51) Int. Cl.³: **H 05 K 3/28**

(30) Priorité: **13.08.80 FR 8017839**

(43) Date de publication de la demande:
**17.02.82 Bulletin 82/7**

(84) Etats contractants désignés:
**BE DE GB IT NL**

(71) Demandeur: **THOMSON-CSF**
**173, Boulevard Haussmann**
**F-75360 Paris Cedex 08(FR)**

(72) Inventeur: **Moraillon, Jean-Yves**
**THOMSON-CSF-SCPI 173, bld Haussmann**
**F-75360 Paris Cedex 08(FR)**

(74) Mandataire: **Trocellier, Roger et al,**
**"THOMSON-CSF" - SCPI 173, bld Haussmann**
**F-75360 Paris Cedex 08(FR)**

(54) **Procédé de vernissage de carte équipée de broches de connexion, et carte ainsi obtenue.**

(57) Procédé permettant d'accroître l'isolement électrique et la protection anti-corosion en permettant le dépôt d'un vernis (8) sur toute la carte y compris les zones de soudure (4) des broches (3).

Le procédé consiste à épargner avant vernissage, les parties extérieures des broches utilisées d'une part, pour l'interconnexion par enfichage et d'autre part, pour effectuer éventuellement des connexions câblées, au moyen d'un dépôt (7) d'une solution à base de savon. Le vernis (8) déposé sur les faces de la carte (1) n'adhère pas sur les parties des broches ainsi protégées. Il suffit, après séchage du vernis, de nettoyer les broches à l'eau chaude et par brossage pour ôter le dépôt (7) et obtenir le produit final.

FIG. 4

EP 0 046 102 A1

## PROCEDE DE VERNISSAGE DE CARTE EQUIPEE DE BROCHES DE CONNEXION ET CARTE AINSI OBTENUE

La présente invention concerne un procédé de vernissage de carte équipée de broches de connexion et la carte ainsi obtenue.

Les circuits électroniques sont généralement portés par des cartes sur lesquelles sont réalisés des circuits imprimés pour l'interconnexion de composants ou de circuits intégrés montés sur la carte. L'interconnexion peut également s'effectuer par connexions enroulées ("wrapping" selon l'appellation anglo-saxonne). Ces cartes sont fréquemment enfichées paralèllement les unes aux autres sur une carte d'interconnexion dite "carte mère", les cartes porteuses de circuits étant appelées "cartes filles". La carte mère comporte des connecteurs mâles constitués par des broches soudées à un pas standard sur un substrat muni de trous métallisés. Une partie de la broche est destinée à l'enfichage des cartes, l'autre partie plus courte et ressortant de l'autre côté du substrat pouvant servir à l'interconnexion dans le cas de connexions câblées.

Dans le but d'accroître l'isolement électrique et de protéger le substrat sans compromettre la qualité de contact des broches, il est connu de procéder à un vernissage des cartes en utilisant avant insolation un masque qui éparge les points de soudure à l'endroit des trous métallisés. Cette technique ne permet qu'une protection partielle puisque l'endroit des soudures où vont se trouver les broches n'est pas protégé par le vernis. Ces parties ne sont par suite pas protégées contre la corrosion ni du point de vue isolement électrique.

2

Le but de l'invention est de remédier à ces inconvénients en procédant à un vernissage qui n'épargne que les parties des broches destinées à l'interconnexion par enfichage avec un connecteur femelle correspondant et les parties destinées à un câblage éventuel, la base des broches soudée au substrat étant protégée par le vernis. Le procédé s'applique à toute carte comportant des broches mâles, carte mère ou carte fille.

Les avantages procurés par l'invention consistent en un procédé d'application industrielle et en un produit obtenu qui présente des isolements importants.

Suivant une caractéristique de l'invention le procédé assure la protection des parties utiles des broches au moyen d'un dépôt d'une solution particulière avant le dépôt du vernis proprement dit sur les deux faces de la carte.

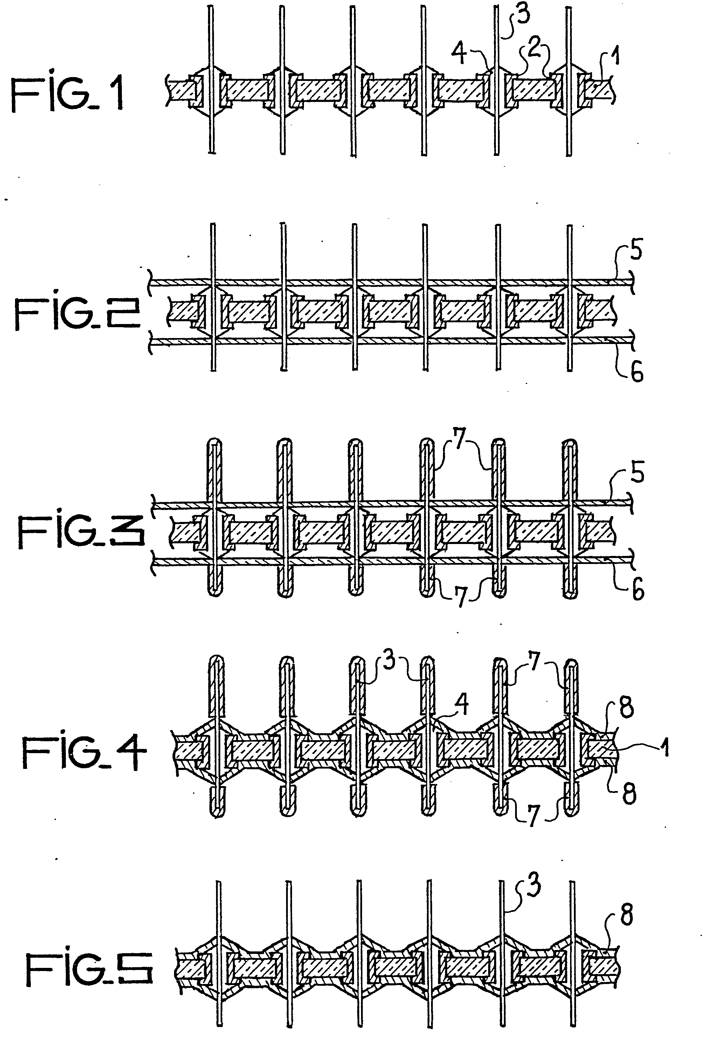

Les particularités et avantages de l'invention apparaîtront dans la description qui suit donnée à titre d'exemple non limitatif à l'aide des Figs. 1 à 5 qui illustrent les différentes étapes du procédé, la Fig. 5 correspondant au produit obtenu.

La Fig. 1 représente en coupe une carte munie de broches mâles. On distingue le substrat 1 en un verre époxy, des trous métallisés le repère 2 indiquant les métallisations, et les broches 3 fixées dans les trous au moyen de soudure 4. Les parties utiles des broches, c'est-à-dire celles extérieures à la carte, sont utilisées d'un côté pour l'interconnexion par enfichage dans un connecteur correspondant et de l'autre côté pour effectuer éventuellement des connexions câblées.

La fig. 2 illustre la première étape du procédé qui consiste à isoler ces parties externes des broches, de la carte, par interposition d'un écran 5 d'un côté et d'un écran 6 sur la face opposée. Ces écrans doivent présenter des perforations à l'endroit des broches et correspondant au diamètre des broches afin de garantir ultérieurement une bonne étanchéité. Suivant un mode d'exécution les écrans 5 et 6 sont constitués par deux feuilles en matériau plastique de faible épaisseur, en polyéthylène par exemple de quelques centièmes de millimètre. Ces feuilles peuvent être plaquées à l'aide d'un élément en mousse acrylique (ou tout autre dispositif plus élaboré), la perforation des feuilles s'effectuant par les extrémités des broches au moment du placage.

Il est alors possible de procéder à l'épargne des broches comme illustré sur la Fig. 3, au moyen d'un dépôt 7 à base de savon. Ce dépôt est effectué par pulvérisation d'une solution savonneuse additionnée d'un colorant. La solution est pulvérisée en couche uniforme sur les broches de manière à assurer leur protection. Le colorant permet, par un contrôle visuel, de vérifier l'uniformité de la protection. La solution est constituée parun mélange de savon, tel qu'un savon de Marseille, avec de l'eau et un alcool, tel un éthanol, dans des proportions en poids qui peuvent être les suivantes : 4 parts d'eau pour une part de savon et environ 2 parts d'alcool. Le colorant est constitué de préférence par du bleu de méthylène pour permettre une bonne observation visuelle du résultat et la proportion de colorant peut être très faible, notamment inférieure à 1 % .

Après séchage du dépôt 7 adhérant aux broches, les écrans 5 et 6 sont enlevés et l'opération de

4

vernissage de la carte est opérée; le vernis est représenté par le dépôt 8 sur la Fig. 4. En fait, le dépôt 7 de protection des broches a été représenté avec des dimensions exagérées pour les besoins de l'illustration et de la compréhension ; il faut considérer quel'épaisseur de ce dépôt 7 est très faible et que le retrait des feuilles 5 et 6 s'effectue sans difficultés.

Après sèchage du vernis 8 par chauffage (polymérisation) ou à l'air ambiant, enlever le dépôt 7 des broches pour obtenir le produit terminal représenté sur la Fig. 5. Le retrait du dépôt 7 est obtenu aisément par un nettoyage à l'eau chaude additionnée d'an agent mouillant et à l'aide d'une brosse. Le colorant permet à ce stade également un contrôle visuel de l'efficacité du nettoyage. Sur la carte obtenue le vernis 8 s'étend au maximum sur les deux faces de la carte, recouvrant en particulier les zones de soudure 4 des broches 3 aux trous metalisés 2, c'est-à-dire les bases de jonction des broches à la carte.

L'invention s'applique à toutes les cartes électroniques munies de broches mâles qui assurent des contacts et qui nécessitent des isolements importants, ou qui doivent être protégées des risques créés par l'environnement, la corosion notamment.

5

# REVENDICATIONS

1 - Procédé de vernissage de carte équipée de broches de connexion, caractérisé par les étapes suivantes :

- 1°) mise en place d'écransde protection (5, 6) plaqués sur le substrat (1) de la carte pour ne laisser apparaître que les parties des broches (3) extérieures à la carte, les écrans étant perforés à l'endroit des broches et au diamètre de celles-ci ;

- 2°) pulvérisation en couche uniforme sur les broches d'une solution savonneuse additionnée d'un colorant permettant par contrôle visuel de vérifier l'uniformité du dépôt (7) ;

- 3°) après séchage du dépôt de protection des broches , retrait des écrans ;

- 4°) vernissage (8) de la carte ;

- 5°) après sèchage du vernis, nettoyage à l'eau chaude additionnée d'agent mouillant et brossage pour éliminer le dépôt protecteur des broches.

2 - Procédé selon la revendication 1, cacractérisé en ce que la solution savonneuse utilisée comporte un mélange de savon, d'eau, d'alcool et un colorant.

3 - Procédé selon la revendication 2, caractérisé en ce que la proportion des éléments de la solution est la suivante, en poids : 4 parts d'eau pour 1 part de savon et environ 2 parts d'alcool.

6

4 - Procédé selon la revendication 2 ou 3, caractérisé en ce que le colorant utilisé est du bleu de méthylène.

5 - Procédé selon l'une quelconque des revendications 2, 3 et 4 , caractérisé en ce que la proportion du colorant dans le mélange est inférieure à 1%.

6 - Procédé selon l'une quelconque des revendications 1 à 5, caractérisé en ce que les écrans sont constitués par deux feuilles en matériau plastique perforées par les extrémités des broches lors d'une manoeuvre de plaquage des feuilles sur le substrat.

7 - Procédé selon la revendication 6, caractérisé en ce que les feuilles sont en polyéthylène.

8 - Carte équipée de broches de connexion et vernie en procédant suivant l'une quelconque des revendications 1 à 7, caractérisée en ce que le vernis déposé (8) s'étend sur toute la carte ainsi qu'à la base (4) des broches (3) ne laissant apparaître que les parties extérieures des broches.

0046102

1/1

FIG. 1

FIG. 2

FIG. 3

FIG. 4

FIG. 5

Office européen des brevets

**RAPPORT DE RECHERCHE EUROPEENNE**

## DOCUMENTS CONSIDERES COMME PERTINENTS

| Catégorie | Citation du document avec indication, en cas de besoin, des parties pertinentes | Revendica-tion concernée |
|---|---|---|
| A | FR - A - 2 258 965 (MATSUSHITA ELECTRIC INDUSTRIAL Co.) <br><br> * Revendications; figures 1-4 * | 1 |

**CLASSEMENT DE LA DEMANDE (Int. Cl.³)**

H 05 K 3/28

**DOMAINES TECHNIQUES RECHERCHES (Int. Cl.³)**

H 05 K 3/28

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons
&: membre de la même famille, document correspondant

Le présent rapport de recherche a été établi pour toutes les revendications

| Lieu de la recherche | Date d'achèvement de la recherche | Examinateur |
|---|---|---|
| La Haye | 05.10.1981 | VAN REETH |

OEB Form 1503.1   06.78